(19) **Europäisches Patentamt European Patent Office Office européen des brevets**

(11) **EP 4 489 545 A1**

(12) **EUROPEAN PATENT APPLICATION**

(43) Date of publication:
**08.01.2025 Bulletin 2025/02**

(51) International Patent Classification (IPC):
*H10B 43/27* (2023.01)          *H10B 43/30* (2023.01)
*H01L 29/792* (2006.01)

(21) Application number: **24164383.2**

(22) Date of filing: **19.03.2024**

(52) Cooperative Patent Classification (CPC):
**H10B 43/27; H01L 29/7926; H10B 43/30**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **03.07.2023 KR 20230085990**

(71) Applicant: **Samsung Electronics Co., Ltd.**
**Suwon-si, Gyeonggi-do 16677 (KR)**

(72) Inventors:
• **HEO, Hoseok**
  **16678 Suwon-si, (KR)**

• **KIM, Kyunghun**
  **16678 Suwon-si, (KR)**
• **KIM, Sunho**
  **16678 Suwon-si, (KR)**
• **KIM, Hyungyung**
  **16678 Suwon-si, (KR)**
• **LEE, Minhyun**
  **16678 Suwon-si, (KR)**
• **CHOI, Seokhoon**
  **16678 Suwon-si, (KR)**
• **HYUN, Seungdam**
  **16678 Suwon-si, (KR)**

(74) Representative: **Elkington and Fife LLP**
**Prospect House**
**8 Pembroke Road**
**Sevenoaks, Kent TN13 1XR (GB)**

(54) **VERTICAL NAND FLASH MEMORY DEVICE AND ELECTRONIC APPARATUS INCLUDING THE SAME**

(57)     A vertical NAND flash memory device and an electronic apparatus including the same are provided. The vertical NAND flash memory device includes a plurality of cell arrays. Each of the plurality of cell arrays includes a channel layer, a charge trap layer, and a plurality of gate electrodes provided on the charge trap layer. The charge trap layer includes a matrix including amorphous metal oxynitride and nanocrystals dispersed in the matrix and including nitride having semiconductor characteristics.

FIG. 2

**Description**

FIELD OF THE INVENTION

The disclosure relates to a vertical NAND flash memory device and an electronic apparatus including the same.

BACKGROUND OF THE INVENTION

As the hard disks of the related art have been replaced by solid state drives (SSDs), NAND flash memory devices, which are non-volatile memory devices, have become widely commercialized. Recently, a vertical NAND flash memory device in which a plurality of memory cells are stacked in a direction perpendicular to a substrate has been developed in accordance with miniaturization and high integration.

In a vertical NAND flash memory device, lateral charge spreading between memory cells may occur due to an increase in the number of stacked stages and a decrease in a height of memory cells. Such lateral charge spreading may deteriorate the charge retention of the memory cells.

SUMMARY OF THE INVENTION

Provided are a vertical NAND flash memory device and an electronic apparatus including the same.

Additional aspects will be set forth in part in the description which follows and, in part, will be apparent from the description, or may be learned by practice of the presented embodiments of the disclosure.

According to an aspect of the disclosure, there is provided a vertical NAND flash memory device including: a plurality of cell arrays, each of the plurality of cell arrays including: a channel layer; a charge trap layer provided on the channel layer, the charge trap layer including: a matrix including amorphous metal oxynitride; and a plurality of nanocrystals provided in the matrix, the plurality of nanocrystals including nitride; and a plurality of gate electrodes provided on the charge trap layer.

By way of example, embodiment may propose a VNAND Flash Memory using amorphous charge trap layer including spatially discrete nanocrystal.

Embodiments may thus facilitate a material/device structure to improve retention of VNAND memory.

By way of further example, a device structure is proposed to improve the retention of VNAND memory, in particular, a device having a charge trap layer separated by a nano-crystal to improve retention by minimizing charge movement in the vertical direction.

Embodiments present a VNAND device in which specific nitride/oxide layers are additionally inserted into the charge trap layer. This has effects on device behavior as follows: First, during subsequent heat treatment, the added nitrogen/oxide layers inhibit crystallization of the existing charge trap layer, resulting in the formation of an amorphous thin film, thus improving the thermal stability of the layer; Second, the insertion layer can create new types of charge trap defects and improve the defect density; Third, the insertion layer can increase the dielectric constant of the entire charge trap layer and improve the capacitance of the entire charge trap layer, thereby contributing to the improvement of the memory window.

An embodiment provides a VNAND flash memory cell formed on a substrate containing transistors or circuits wherein memory cells are formed in a center of a layer in which word lines composed of metal and nonconductors are repeatedly stacked, wherein on sides of a vertically formed hole, a barrier dielectric, a charge trap layer, a tunneling dielectric, and a semiconductor are stacked sequentially, and a cavity inside is filled with filling dielectric, and wherein the charge trap layer has a structure of nanocrystals embedded in a dielectric layer that is a matrix.

The plurality of nanocrystals may be spatially separated from each other in the matrix.

The matrix may further include metal oxynitride having a permittivity greater than a permittivity of silicon nitride.

The matrix may further include at least one of AlON, ZrON, LaON, AlSiON, HfAlON, LaSiON, AlZrON, LaAlON, HfAlON, or ZrSiON.

Each of the plurality of nanocrystals may include semiconductor nitride may have a bandgap greater than 1 eV and less than a bandgap of a material of the matrix.

Each of the plurality of nanocrystals may be at least one of AlN, GaN, GeN, SiN, CN, InN, YN, ScN, or ZrN.

Each of the plurality of nanocrystals may have a size of about 0.5 nm to about 5 nm.

Each of the plurality of nanocrystals may have a size of about 1 nm to about 3 nm.

The plurality of nanocrystals may be formed by heat treating the amorphous metal oxynitride of the matrix at a heat treatment temperature.

The heat treatment temperature of the amorphous metal oxynitride may be about 900 °C to about 1300 °C.

The plurality of nanocrystals may be buried in the matrix.

One or more of the plurality of nanocrystals may be provided in a boundary between the matrix and a layer adjacent to the matrix.

Each of the plurality of cell arrays may be vertically provided to extend on a substrate.

A channel hole extending in a direction perpendicular to the substrate may be formed inside the channel layer.

An inside of the channel hole may be filled with an insulating layer.

Each of the channel layer and the charge trap layer may be formed in a cylindrical shape surrounding the channel hole.

The plurality of gate electrodes may be spaced apart from each other in a direction perpendicular to the substrate, and wherein each of the plurality of gate electrodes may surround the charge trap layer.

A tunneling dielectric layer may be provided between the channel layer and the charge trap layer.

A barrier dielectric layer may be provided between the charge trap layer and each of the plurality of gate electrodes.

According to another aspect of the disclosure, there is provided an electronic apparatus including: a plurality of cell arrays, each of the plurality of cell arrays including: a channel layer; a charge trap layer provided on the channel layer, the charge trap layer including: a matrix including amorphous metal oxynitride; and a plurality of nanocrystals provided in the matrix, the plurality of nanocrystals including nitride; and a plurality of gate electrodes provided on the charge trap layer.

BRIEF DESCRIPTION OF DRAWINGS

The above and other aspects, features, and advantages of certain embodiments of the disclosure will be more apparent from the following description taken in conjunction with the accompanying drawings, in which:

FIG. 1 is a perspective view schematically illustrating a vertical NAND flash memory device according to an embodiment;

FIG. 2 is a cross-sectional view of a cell array shown in FIG. 1;

FIG. 3 is an enlarged view of a portion A of a memory cell shown in FIG. 2;

FIG. 4A illustrates a transmission electron microscopy (TEM) image of an amorphous AlON thin film deposited on a substrate;

FIG. 4B illustrates a TEM image of the amorphous AlON thin film obtained by heat treating the amorphous AlON thin film shown in FIG. 4A;

FIG. 5A is a cross-sectional view illustrating a memory cell of a vertical NAND flash memory device according to a comparative example;

FIG. 5B schematically illustrates an electronic band structure taken along a line I-I' of FIG. 5A;

FIG. 6A is a cross-sectional view illustrating a memory cell of a vertical NAND flash memory device according to an embodiment;

FIG. 6B schematically illustrates an electronic band structure taken along a line II-II' in FIG. 6A;

FIG. 6C schematically illustrates an electronic band structure taken along a line III-III' in FIG. 6A;

FIG. 7 illustrates an example of trap energy of a charge trap layer in a vertical NAND flash memory device according to a comparative example;

FIG. 8A illustrates an example of trap energy of a charge trap layer in a vertical NAND flash memory device according to an embodiment;

FIG. 8B illustrates an example of a trap density of a charge trap layer in a vertical NAND flash memory device according to an embodiment;

FIG. 9A illustrates another example of trap energy of a charge trap layer in a vertical NAND flash memory device according to an embodiment;

FIG. 9B illustrates another example of a trap density of a charge trap layer in a vertical NAND flash memory device according to an embodiment;

FIG. 10 is a cross-sectional view of a vertical NAND flash memory device according to another embodiment; and

FIG. 11 is a conceptual diagram schematically illustrating a device architecture applicable to an electronic apparatus according to an embodiment.

DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, embodiments will be described in detail with reference to the accompanying drawings. Like reference numerals in the drawings denote like elements, and the size of each element in the drawings may be exaggerated for clarity and convenience of description. Meanwhile, embodiments described below are merely examples, and various modifications may be made from these embodiments.

Hereinafter, what is described as "above" or "on" may include those directly on, underneath, left, and right in contact, as well as above, below, left, and right in non-contact. The singular forms are intended to include the plural forms as well, unless the context clearly indicates otherwise. Also, when a part "includes" any element, it means that the part may further include other elements, rather than excluding other elements, unless otherwise stated.

The term "the" and the similar indicative terms may be used in both the singular and the plural. When there is no explicit description of the order of steps constituting a method or no contrary description thereto, these steps may be performed in an appropriate order, and are not limited to the order described.

In addition, the terms "... unit", "module", etc. described herein mean a unit that processes at least one function or operation, may be implemented as hardware or software, or may be implemented as a combination of hardware and software.

Connections of lines or connection members between elements shown in the drawings are illustrative of functional connections and/or physical or circuitry connections, and may be replaced in an actual device, or may be represented as additional various functional connections, physical connections, or circuitry connections.

The use of all examples or example terms is merely for describing the technical concept in detail, and the scope thereof is not limited by these examples or example terms unless limited by the claims.

In a vertical NAND flash memory device, data retention is one of the key reliability factors, that is, a characteristic to store charges in a charge trap layer for a long time. When a distance between memory cells is reduced to increase a memory density in the vertical NAND flash memory device, trapped charges may move between the memory cells, and accordingly, the charge retention characteristic may deteriorate.

In the vertical NAND flash memory device, charges may move from a charge trap layer to a tunneling dielectric layer through trap-assisted tunneling or thermal emission in a direction perpendicular to the charge trap layer. A degree of such a charge movement may be determined by a conduction band offset (CBO) at an interface between the charge trap layer and the tunneling dielectric layer.

The charge movement may occur in a direction parallel to the charge trap layer by a lateral migration according to a gradient of charge concentration. The charge movement in the direction parallel to the charge trap layer may be governed by Poole-Frenkel tunneling.

A current density due to Poole-Frenkel tunneling may be expressed as Poole-Frenkel Conduction Equation (equation 1) below.

$$J = q\mu N_c E \, exp\left(\frac{-q(E_T - \sqrt{qE/\pi\varepsilon})}{kT}\right) \qquad \cdots \quad \text{(equation 1)}$$

Here, J is current Density, q is electronic charge, $\mu$ is carrier mobility $N_c$ is density of states in conduction band, E is electric field, $E_T$ is trap energy, $\varepsilon$ is permittivity, $\kappa$ is Boltzmann constant, and T is temperature.

The charge movement in the direction parallel to the charge trap layer by Poole-Frenkel tunneling may be determined by the trap energy $E_T$ and the trap density $N_T$ in the charge trap layer. Trap energy refers to a voltage barrier that electrons in a material need to cross to move from one atom to another. In other words, the trap energy refers to a depth of a trap state relative to a conduction band minimum (CBM) of the material. Trap density refers to the number of trapped charges per unit volume. The trap density may be calculated by using a charge pumping method. The charge retention characteristic in the direction parallel to the charge trap layer may be improved by a high trap energy and a high trap density.

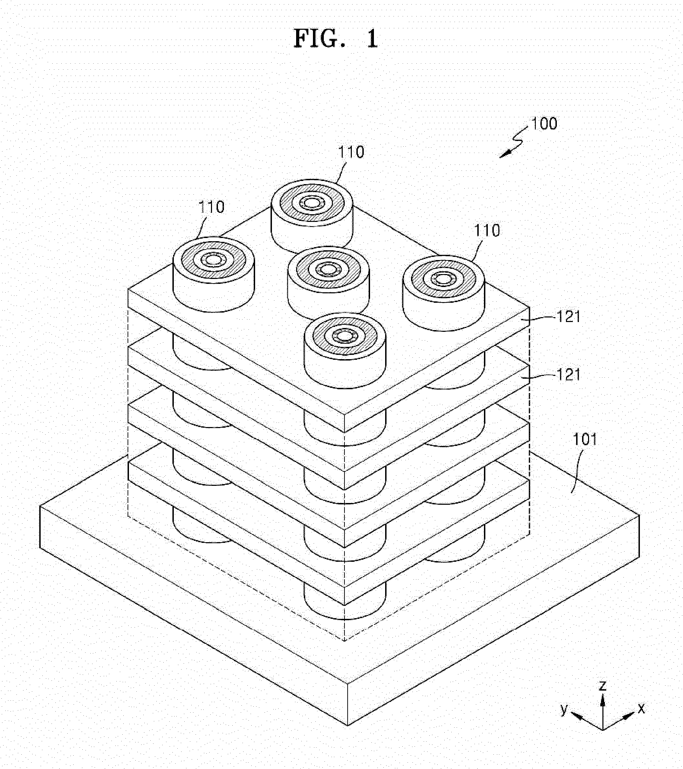

FIG. 1 is a perspective view schematically illustrating a vertical NAND flash memory device 100 according to an embodiment.

Referring to FIG. 1, the vertical NAND flash memory device 100 includes a plurality of cell arrays 110 provided on a substrate 101. Each cell array 110 may be provided to extend in a direction perpendicular to the substrate 101. For example, each cell array 110 may extend in a z-axis direction in FIG. 1. The plurality of cell arrays 110 may be provided on the substrate 101 in various forms.

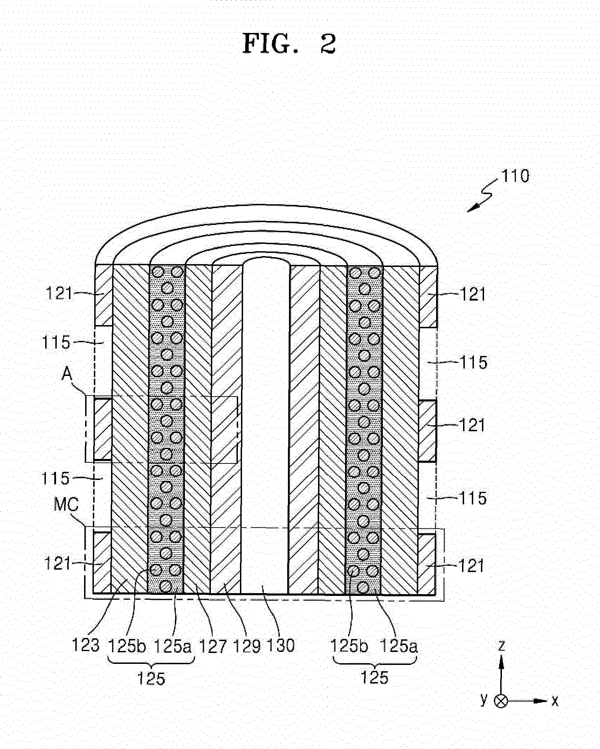

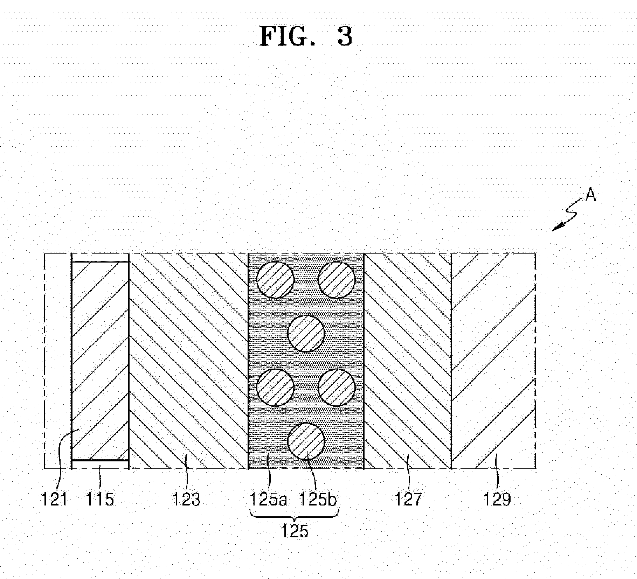

FIG. 2 is a cross-sectional view of each cell array 110 shown in FIG. 1. FIG. 3 is an enlarged view of a portion A of a memory cell MC shown in FIG. 2.

Referring to FIGS. 1, 2 and 3, the cell array 110 includes a plurality of memory cells MC stacked in a direction (the z-axis direction) perpendicular to the substrate 101. The cell array 110 includes a plurality of gate electrodes 121 spaced apart from each other and stacked in a direction perpendicular to the substrate 101. Moreover, the cell array 110 includes a barrier dielectric layer 123, a charge trap layer 125, a tunneling dielectric layer 127, and a channel layer 129 provided inside the gate electrodes 121. According to an embodiment, the barrier dielectric layer 123, the charge trap layer 225, the tunneling dielectric layer 127, and the channel layer 129 may be provided in this sequential order inside the gate electrode parallel to the substrate 101. Each of the barrier dielectric layer 123, the charge trap layer 125, the tunneling dielectric layer 127, and the channel layer 129 may be provided to extend vertically on the substrate 101 and be shared by the plurality of memory cells MC.

Each memory cell MC may include a gate electrode 121, the barrier dielectric layer 123, the charge trap layer 125, the tunneling dielectric layer 127, and the channel layer 129 provided at positions corresponding to the gate electrode 121. A source and a drain may be provided in the channel layer 129 positioned below and above each memory cell MC, and a channel corresponding to the gate electrode 121 may be formed in the channel layer 129 between the source and drain. In an example case in which a certain voltage is applied to the gate electrode 121 in each memory cell MC, charges flowing between the source and the drain in the channel layer 129 corresponding to the gate electrode 121 may pass through the tunneling dielectric layer 127 and be trapped in the charge trap layer 125 so that information may be stored.

According to an embodiment, interlayer insulating layers 115 and gate electrodes 121 may be alternately stacked on the substrate 101 in a direction perpendicular to the substrate 101. Each interlayer insulating layer 115 and each gate electrode 121 may be provided in parallel on the substrate 101. The substrate 101 may include various materials. For example, the substrate 110 may include a single crystal silicon substrate, a compound semiconductor substrate, or a silicon on insulator (SOI) substrate. However, the disclosure is not limited thereto, and as such, according to another embodiment, the substrate 110 may include a different type of substrate. In addition, the substrate 101 may further include, for example, an impurity region by doping, an electronic apparatus such as a transistor, or a periphery circuit selecting and controlling memory cells storing data.

According to an embodiment, the gate electrode 121 may control the channel layer 129 corresponding to gate electrode 121. According to an embodiment, the vertical NAND flash memory device 100 may include a word line electrically connected to the gate electrode 121. The gate electrode 121 may include, for example, a metal material having excellent electrical conductivity such as gold (Au), a metal nitride, impurity-doped silicon, or a two-dimensional (2D) conductive material. However, this is merely an example, and as such, according to another embodiment, the gate electrode 121 may include various other materials. The interlayer insulating layer 115 may be a spacer layer for insulation between the gate electrodes 121. For example, the interlayer insulating layer 115 may serve as a spacer layer for insulation between the gate electrodes 121. The interlayer insulating layer 115 may include, for example, silicon oxide or silicon nitride, but is not limited thereto.

According to an embodiment, channel holes are formed to pass through the interlayer insulating layers 115 and the gate electrodes 121 in a direction (z-axis direction) perpendicular to the substrate 101. Such a channel hole may be formed to have, for example, a circular cross-section.

The barrier dielectric layer 123, the charge trap layer 125, the tunneling dielectric layer 127, and the channel layer 129 are sequentially provided on the inner wall of the channel hole. Each of the barrier dielectric layer 123, the charge trap layer 125, the tunneling dielectric layer 127, and the channel layer 129 may be formed to have a cylindrical shape extending in a direction perpendicular to the substrate 101. A filling insulating layer 130 may be provided inside the channel layer 129 to fill the channel hole. The filling insulating layer 130 may include, for example, silicon oxide or air, but the disclosure is not limited thereto.

The channel layer 129 may include a semiconductor material. For example, the channel layer 129 may include, for example, Si, Ge, SiGe, a group III-V semiconductor, etc. Also, the channel layer 129 may include, for example, an oxide semiconductor, a nitride semiconductor, an oxynitride semiconductor, a 2D semiconductor material, a quantum dot (QD), or an organic semiconductor. The oxide semiconductor may include, for example, InGaZnO, etc., the 2D semiconductor material may include, for example, transition metal dichalcogenide (TMD) or graphene, and the QD may include a colloidal QD, a nanocrystal structure, etc. However, this is only an example, and the present embodiment is not limited thereto.

The channel layer 129 may further include a dopant. The dopant may include a p-type dopant or an n-type dopant. The p-type dopant may include, for example, a group III element such as B, Al, Ga, and In, and the n-type dopant may include a group V element, such as P, As, and Sb.

The barrier dielectric layer 123, the charge trap layer 125, and the tunneling dielectric layer 127 are provided between the gate electrodes 121 and the channel layer 129. The barrier dielectric layer 123 is provided on the inner wall of the channel hole to contact the interlayer insulating layers 115 and the gate electrodes 121. The barrier dielectric layer 123 may include, for example, silicon oxide or metal oxide, but is not limited thereto. The tunneling dielectric layer 127 is a layer through which charges are tunneled, and may include, for example, silicon oxide or metal oxide, but is not limited thereto.

The charge trap layer 125 is provided between the barrier dielectric layer 123 and the tunneling dielectric layer 127. The charge trap layer 125 includes a matrix 125a and nanocrystals 125b provided inside the matrix 125a.

The matrix 125a may include amorphous metal oxynitride. The matrix 125a may include metal oxynitride having a greater permittivity than that of silicon nitride. For example, the matrix 125a may include at least one of AlON, ZrON, LaON, AlSiON, HfAlON, LaSiON, AlZrON, LaAlON, HfAlON, or ZrSiON, but the disclosure is not limited thereto.

The nanocrystals 125b may be randomly distributed inside the matrix 125a. The nanocrystals 125b may be buried inside the matrix 125a. The nanocrystals 125b may be spatially separated from each other inside the matrix 125a.

Each of the nanocrystals 125b may have a spherical or ellipsoidal shape. However, the disclosure is not limited thereto, and as such, the nanocrystals 125b may have another shape. For example, each of the nanocrystals 125b may have a size of about 0.5 nm to about 5 nm. For example, each of the nanocrystals 125b may have a size of about 1 nm to about 3 nm.

Each of the nanocrystals 125b may include semiconductor nitride having a bandgap less than that of the material of the matrix 125a. For example, each of the nanocrystals 125b may include semiconductor nitride having the bandgap greater than 1 eV and less than the bandgap of the material of the matrix 125a. For example, each of the nanocrystals 125b may include at least one of AlN, GaN, GeN, SiN, CN, InN, YN, ScN, or ZrN. However, the disclosure is not limited thereto, and as such, the nanocrystals 125b may include other materials. Each of the nanocrystals 125b may have, for example, a hexagonal structure or a wurtzite structure. However, the disclosure is not limited thereto, and as such, the nanocrystals 125b may have another structure.

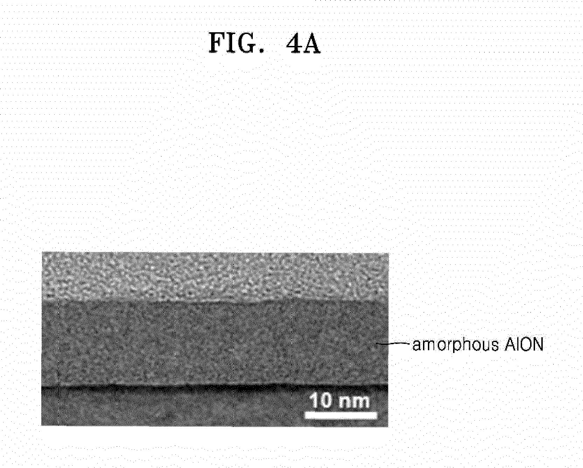

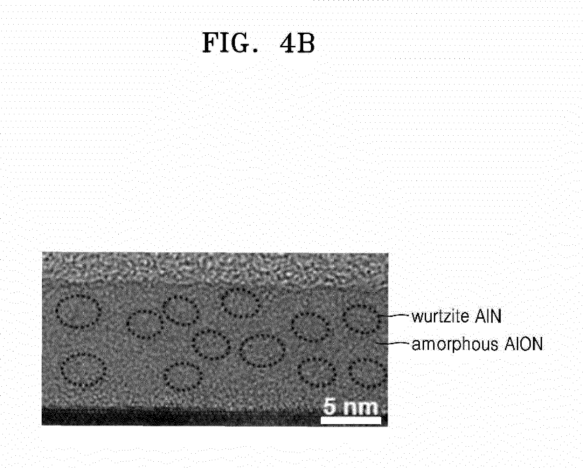

The nanocrystals 125b may be formed by heat treating amorphous metal oxynitride of the matrix 125a at a certain temperature. For example, the temperature may be approximately about 900 °C to about 1300 °C. FIGS. 4A and 4B illustrate transmission electron microscopy (TEM) images of AlN nanocrystals formed in an amorphous AlON thin film by heat treating the amorphous AlON thin film. FIG. 4A illustrates the TEM image of the amorphous AlON thin film formed by cross depositing AlO and AlN on a substrate. Also, FIG. 4B illustrates the TEM image of the amorphous AlON thin film shown in FIG. 4A obtained by heat treating the amorphous AlON thin film at 1100 °C. Referring to FIG. 4B, it may be seen that AlN nanocrystals each having the size of approximately 5 nm and having a wurtzite structure are spatially separated from each other inside the amorphous AlON thin film.

According to an embodiment, the charge trap layer 125 include amorphous metal oxynitride in which the nanocrystals 125b having semiconductor characteristics are dispersed, thereby increasing trap energy and trap density, as described below, and improving a charge retention characteristic by suppressing movement of trapped charges between memory cells MC. Accordingly, memory operating characteristics may be improved by reducing a threshold voltage.

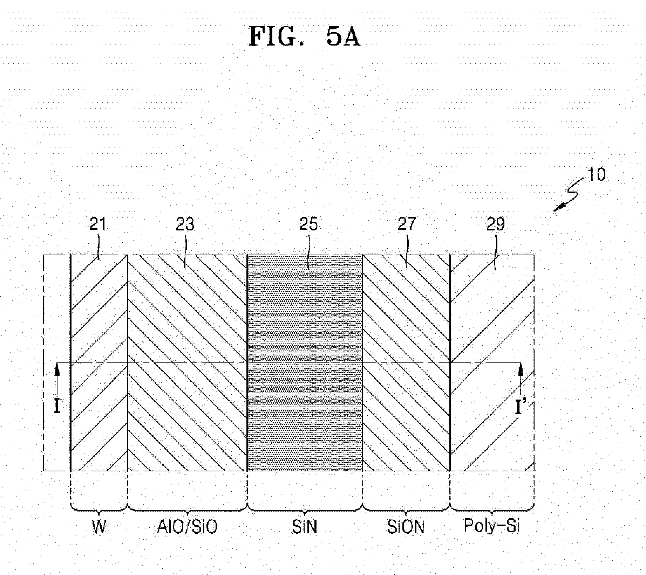

FIG. 5A is a cross-sectional view illustrating a memory cell of a vertical NAND flash memory device 10 according to a comparative example. Referring to FIG. 5A, a barrier dielectric layer 23, a charge trap layer 25, a tunneling dielectric layer 27, and a channel layer 29 are sequentially provided inside a gate electrode 21. The charge trap layer 25 includes SiN, the gate electrode 21 includes W (tungsten), the barrier dielectric layer 23 includes AlO/SiO, the tunneling dielectric layer 27 includes SiON, and the channel layer 29 includes poly-Si.

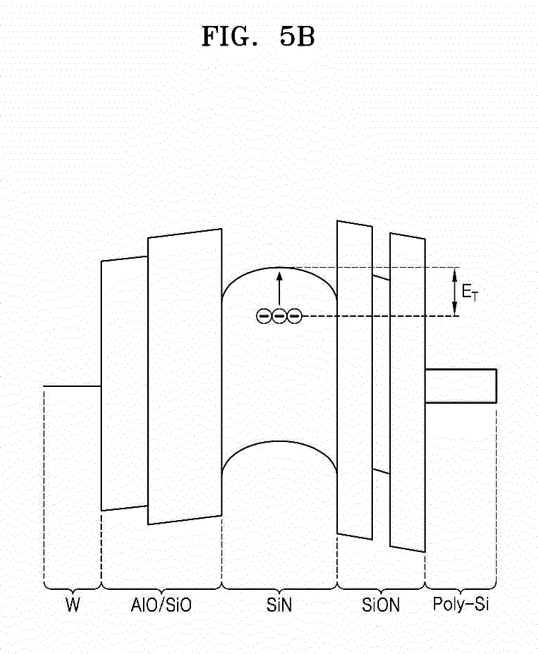

FIG. 5B schematically illustrates an electronic band structure taken along a line I-I' of FIG. 5A. Referring to FIG. 5B, the trap energy $E_T$ of SiN of the charge trap layer 25 is less than the trap energy $E_T$ of AlON of a matrix of the charge trap layer 125 according to an embodiment described below.

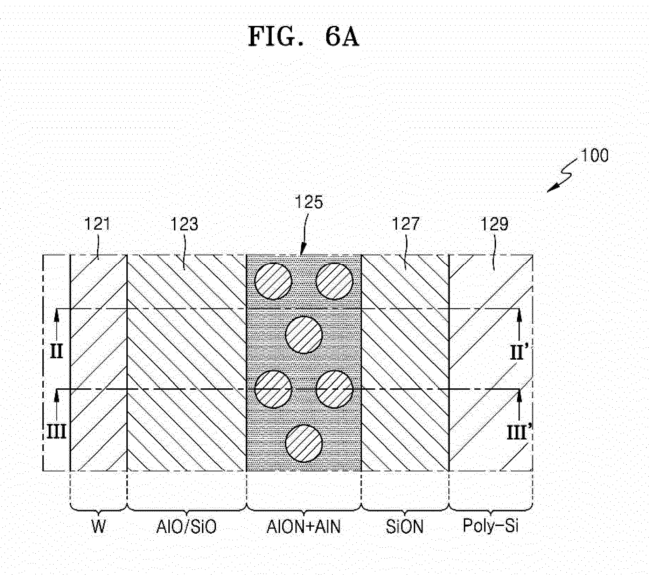

FIG. 6A is a cross-sectional view illustrating a memory cell of a vertical NAND flash memory device 100 according to an embodiment. Referring to FIG. 6A, the barrier dielectric layer 123, the charge trap layer 125, the tunneling dielectric layer 127, and the channel layer 129 are sequentially provided inside the gate electrode 121. The charge trap layer 125 includes amorphous AlON including AlN nanocrystals, the gate electrode 121 includes W (tungsten), the barrier dielectric layer 23 includes AlO/SiO, the tunneling dielectric layer 27 includes SiON, and the channel layer 29 includes poly-Si.

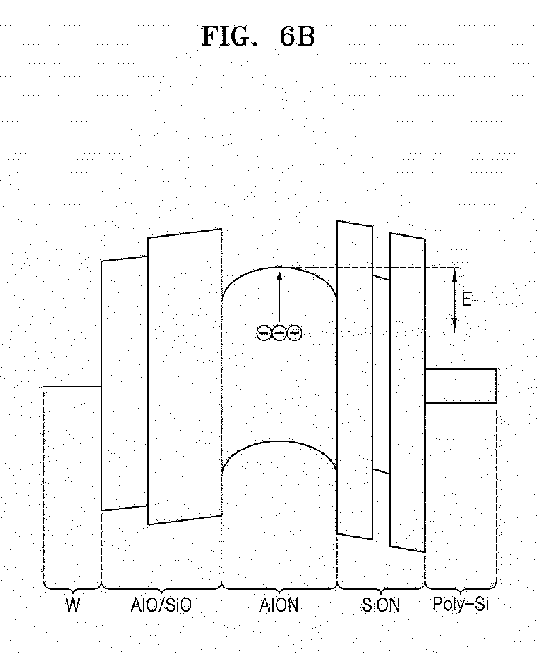

FIG. 6B schematically illustrates an electronic band structure taken along a line II-II' in FIG. 6A. Referring to FIG. 6B, it can be seen that the trap energy $E_T$ of amorphous AlON of a matrix of the charge trap layer 125 is higher than the trap energy $E_T$ of SiN shown in FIG. 5B.

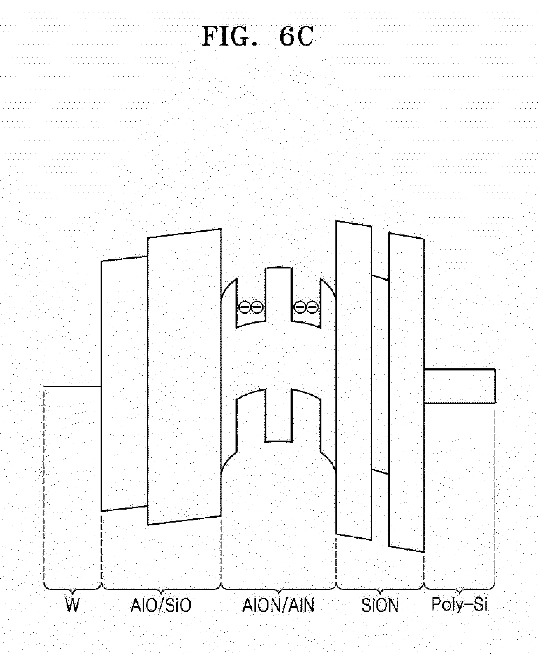

FIG. 6C schematically illustrates an electronic band structure taken along a line III-III' in FIG. 6A. Referring to FIG. 6C, in the charge trap layer 125, AlN nanocrystals each having a bandgap smaller than that of amorphous AlON are spatially separated from each other inside amorphous AlON. Therefore, the trap density $N_T$ may be increased by forming an additional barrier for charges trapped in the AlN nanocrystals by a type-I band alignment structure at an interface between amorphous AlON and AlN nanocrystals.

Hereinafter, with respect to a charge trap layer of the vertical NAND flash memory device according to a comparative example and a charge trap layer of a vertical NAND flash memory device according to an embodiment, the trap energy $E_T$ and the trap density $N_T$ are evaluated by utilizing Poole-Frenkel Conduction Equation (Equation 1) and the charge pumping method described above.

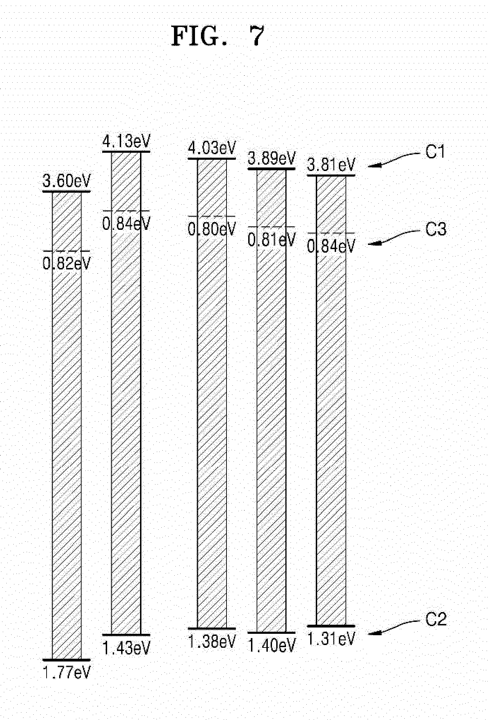

FIG. 7 illustrates an example of a trap energy of the charge trap layer 25 in the vertical NAND flash memory device 10 according to a comparative example. FIG. 7 illustrates results of using a SiN thin film as the charge trap layer 25. In FIG. 7, left two graphs show the results of the SiN thin film formed by plasma enhanced atomic layer deposition (PEALD), and right three graphs show the results of the SiN thin film formed by sputtering.

In FIGS. 7, 8A and 9A, "C1" and "C2" represent a CBM and a valence band maximum (VBM), respectively, and "C3" represents the trap energy $E_T$. This is the same below.

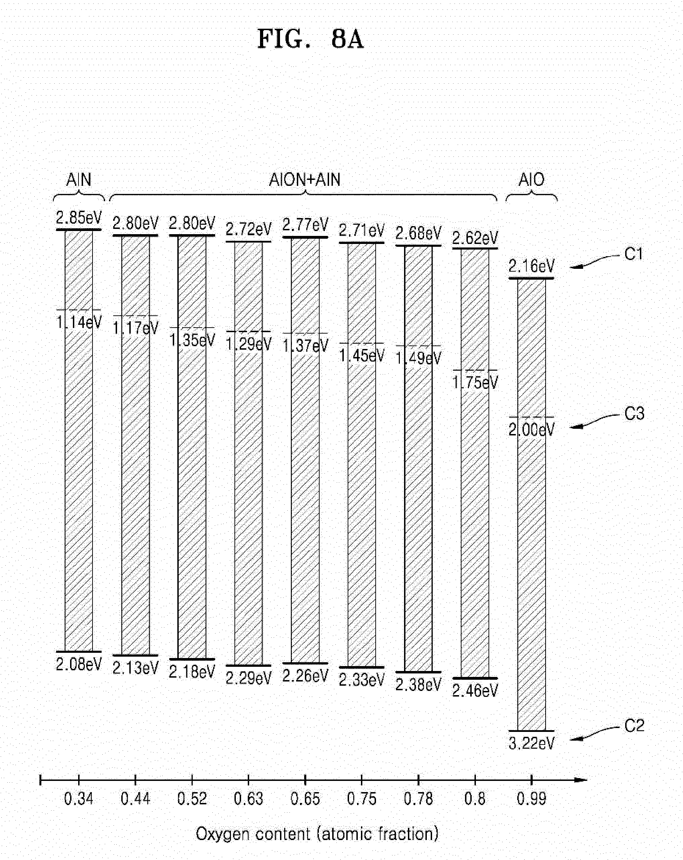

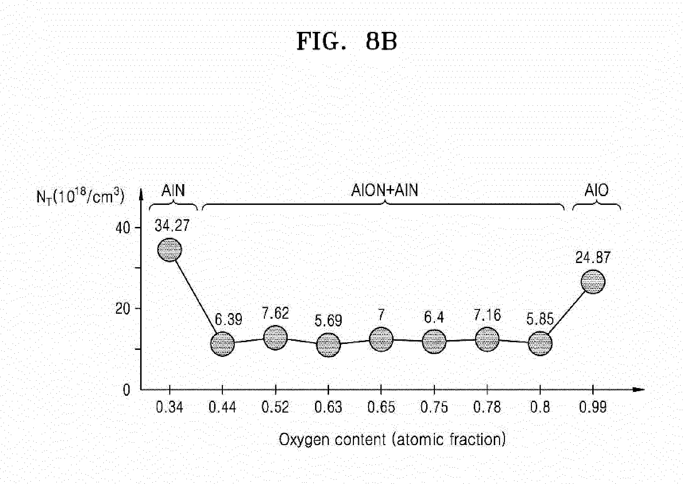

FIGS. 8A and 8B respectively illustrate examples of trap energy and trap density of the charge trap layer 125 in the vertical NAND flash memory device 100 according to an embodiment. FIGS. 8A and 8B show results of a case where AlN nanocrystals are formed in an amorphous AlON thin film by heat treating the amorphous AlON thin film at 800 °C. In FIGS. 8A and 8B, oxygen content represents an atomic fraction of oxygen among oxygen and nitrogen.

Referring to FIG. 8A, it may be seen that the amorphous AlON thin film including AlN nanocrystals has a higher trap energy than that of a SiN thin film shown in FIG. 7 described above. In addition, referring to FIG. 8B, it may be seen that the amorphous AlON thin film including AlN nanocrystals has a high trap density.

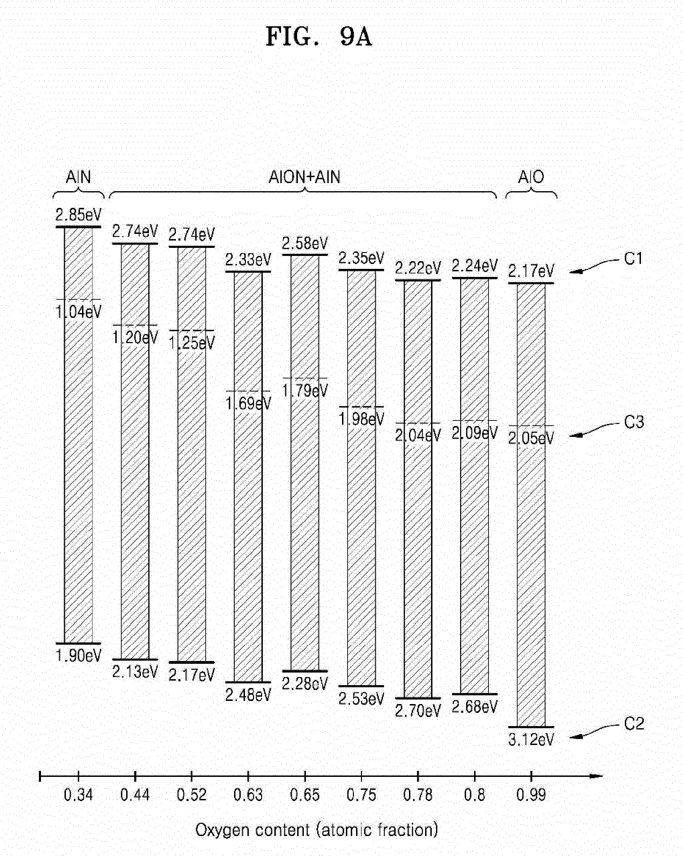

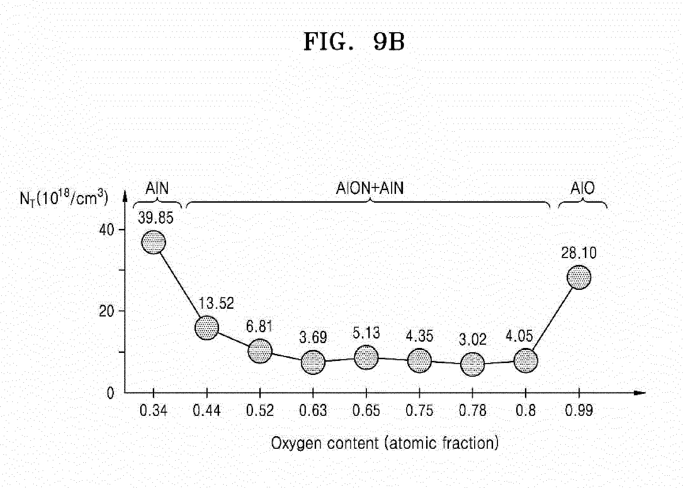

FIGS. 9A and 9B illustrate other examples of trap energy and trap density of the charge trap layer 125 in a vertical NAND flash memory device according to an embodiment. FIGS. 9A and 9B illustrate results of a case where AlN nanocrystals are formed in an amorphous AlON thin film by heat treating the amorphous AlON thin film at 1100 °C.

Referring to FIGS. 9A and 9B, it may be seen that the amorphous AlON thin film including AlN nanocrystals has a higher trap energy than that of a SiN thin film shown in FIG. 7, and also, it may be seen that the amorphous AlON thin film including AlN nanocrystals has a high trap density.

According to the embodiment above, the charge trap layer 125 includes a matrix 125a and nanocrystals 125b dispersed in the matrix 125a. A driving voltage may be reduced by forming the matrix 125a of amorphous metal oxynitride having a greater permittivity than that of silicon nitride. Amorphous metal oxide has a lower CBO and higher trap energy $E_T$ than silicon nitride. Therefore, a charge movement in a direction perpendicular to the charge trap layer 125 may be suppressed by a barrier increase at an interface between the charge trap layer 125 and the tunneling dielectric layer 127 due to a decrease in the CBO, and an increase in the trap energy $E_T$ may suppress the charge movement in a direction parallel to the charge trap layer 125.

The nanocrystals 125b include a semiconductor material having a bandgap smaller than that of a material of the matrix 125a, thereby effectively confining charges inside the nanocrystals 125b, and accordingly, increasing the trap density $N_T$. As described above, the charge trap layer 125 includes amorphous metal oxynitride in which the nanocrystals 125b having semiconductor characteristics are dispersed, thereby increasing the trap energy $E_T$ and the trap density $N_T$, and improving a charge retention characteristic by suppressing movement of trapped charges between the memory cells MC. Accordingly, memory operating characteristics may be improved by reducing a threshold voltage.

In the vertical NAND flash memory device 100 shown in FIGS. 1 to 3 described above, the nanocrystals 125b included in the charge trap layer 125 are provided to be buried inside the matrix 125a, but are not limited thereto, and, as will be described below, some of the nanocrystals 125b may be exposed to the outside of the matrix 125a.

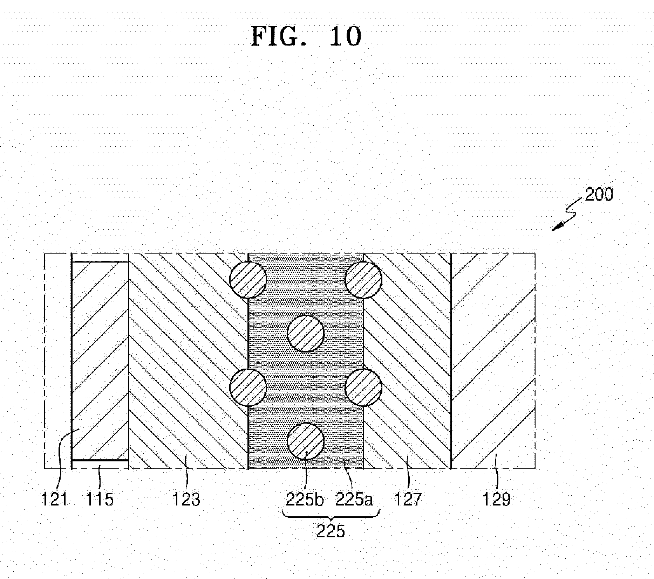

FIG. 10 is a cross-sectional view of a vertical NAND flash memory device 200 according to another embodiment. FIG. 10 illustrates a cross section of the memory cell MC of the vertical NAND flash memory device 200 for convenience. Hereinafter, differences from the above-described embodiment are mainly described.

Referring to FIG. 10, the barrier dielectric layer 123, a charge trap layer 225, the tunneling dielectric layer 127, and the channel layer 129 are provided inside the gate electrode 121. According to an embodiment, the barrier dielectric layer 123, the charge trap layer 225, the tunneling dielectric layer 127, and the channel layer 129 may be provided in this sequential order inside the gate electrode. The gate electrode 121, the barrier dielectric layer 123, the tunneling dielectric layer 127, and the channel layer 129 have been described above, and thus, descriptions thereof are omitted.

The charge trap layer 225 is provided between the barrier dielectric layer 123 and the tunneling dielectric layer 127. The charge trap layer 225 includes a matrix 225a and nanocrystals 225b provided in the matrix 225a.

The matrix 225a may include amorphous metal oxynitride, for example, metal oxynitride having a greater permittivity than that of silicon nitride. For example, the matrix 125a may include at least one of AlON, ZrON, LaON, AlSiON, HfAlON, LaSiON, AlZrON, LaAlON, HfAlON, or ZrSiON, but the disclosure is not limited thereto.

The nanocrystals 225b may be spatially separated from each other. According to an embodiment, some of the nanocrystals 225b may be exposed to the outside of the matrix 225a, and others may be buried inside the matrix 225a. For example, the nanocrystals 225b may include a first group of nanocrystals 225b provided inside the matrix 225a and a second group of nanocrystals 225b provided at a boundary between the matrix 225a and a layer adjacent to the matrix 225a. For example, the nanocrystals 225b of the second group may be provided in the 225a such that a first portion of the nanocrystal 225b is provided in the matrix 225a and a second portion of the nanocrystal 225b is provided in the layer adjacent to the matrix 225a. The nanocrystals 225b exposed to the outside of the matrix 225a may form an interface between the charge trap layer 225 and the tunneling dielectric layer 127 and an interface between the charge trap layer 225 and the barrier dielectric layer 123.

Each of the nanocrystals 225b may have a spherical or ellipsoidal shape, for example, but this is merely an example. For example, each of the nanocrystals 225b may have a size of about 0.5 nm to about 5 nm (e.g., about 1 nm to about 3 nm). Each of the nanocrystals 225b may include semiconductor nitride having a bandgap less than that of the material of the matrix 225a. Each of the nanocrystals 225b may include semiconductor nitride having the bandgap greater than 1 eV and less than the bandgap of the material of the matrix 225a. For example, each of the nanocrystals 125b may include at least one of AlN, GaN, GeN, SiN, CN, InN, YN, ScN, or ZrN, but is not limited thereto.

In the above, a case where the nanocrystals 225b are provided at the interface between the charge trap layer 225 and the tunneling dielectric layer 127 and the interface between the charge trap layer 225 and the barrier dielectric layer 123 has been described, but this is only an example. The nanocrystals 225b may be provided only at one of the interface between the charge trap layer 225 and the tunneling dielectric layer 127 and the interface between the interface between the charge trap layer 225 and the barrier dielectric layer 123.

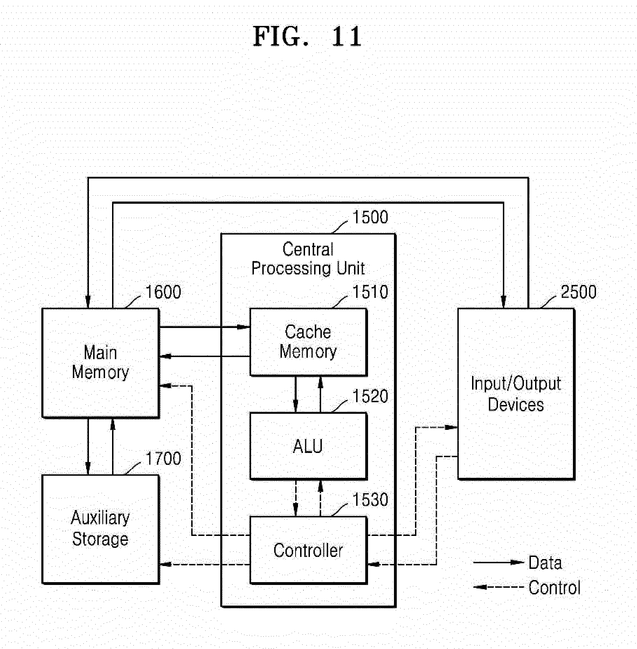

The vertical NAND flash memory devices 100 and 200 described above may be used for data storage in various electronic apparatuses. FIG. 11 is a conceptual diagram schematically illustrating a device architecture applicable to an electronic apparatus according to an embodiment.

Referring to FIG. 11, an electronic device may include a cache memory 1510, an ALU 1520, and a controller 1530 constituting a central processing unit (CPU) 1500, and the cache memory 1510 may include a static random access memory (SRAM). In addition, the electronic device a main memory 1600, an auxiliary storage 1700 and Input/Output (IO) devices 2500. The main memory 1600 may include a DRAM device, and the auxiliary storage 1700 may include the vertical NAND flash memory device 100 described above according to one or more embodiments. According to an embodiment, the electronic device architecture may be implemented in a form in which computing unit devices and memory unit devices are adjacent to each other in one chip without distinguishing sub-units.

According to one or more embodiments discussed above, in the vertical NAND flash memory device, a charge trap layer includes a matrix and nanocrystals dispersed in the matrix. A driving voltage may be reduced by forming the matrix of amorphous metal oxynitride having a greater permittivity than that of silicon nitride, and a movement of charges in directions perpendicular to and parallel to the charge trap layer may be suppressed by amorphous metal oxynitride having the trap energy higher than that of silicon nitride. In addition, each of nanocrystals may include semiconductor nitride having a bandgap less than that of a material of the matrix, thereby confining charges inside the nanocrystals, and accordingly, increasing the trap density. As described above, the charge trap layer includes amorphous metal oxynitride in which the nanocrystals having semiconductor characteristics are dispersed, thereby increasing the trap energy and the trap density, and improving a charge retention characteristic by suppressing the movement of trapped charges between memory cells. Accordingly, memory operating characteristics may be improved by reducing a threshold voltage. Although the embodiment has been described above, this is merely an example, and various modifications are possible therefrom to those skilled in the art.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

**Claims**

1. A vertical NAND flash memory device comprising:
   a plurality of cell arrays, each of the plurality of cell arrays comprising:

   a channel layer;
   a charge trap layer provided on the channel layer, the charge trap layer comprising:

   a matrix comprising amorphous metal oxynitride; and
   a plurality of nanocrystals provided in the matrix, the plurality of nanocrystals comprising nitride; and

   a plurality of gate electrodes provided on the charge trap layer.

2. The vertical NAND flash memory device of claim 1, wherein the plurality of nanocrystals are spatially separated from each other in the matrix.

3. The vertical NAND flash memory device of claim 1 or 2, wherein the matrix further comprises metal oxynitride having a permittivity greater than a permittivity of silicon nitride, and optionally wherein the matrix further comprises at least one of AlON, ZrON, LaON, AlSiON, HfAlON, LaSiON, AlZrON, LaAlON, HfAlON, or ZrSiON.

4. The vertical NAND flash memory device of any preceding claim, wherein each of the plurality of nanocrystals comprises semiconductor nitride having a bandgap greater than 1 eV and less than a bandgap of a material of the matrix, and optionally wherein each of the plurality of nanocrystals comprises at least one of AlN, GaN, GeN, SiN, CN, InN, YN, ScN, or ZrN.

5. The vertical NAND flash memory device of any preceding claim, wherein each of the plurality of nanocrystals has a size of 0.5 nm to 5 nm, and optionally wherein each of the plurality of nanocrystals has a size of 1 nm to 3 nm.

6. The vertical NAND flash memory device of any preceding claim, wherein the plurality of nanocrystals are formed by heat treating the amorphous metal oxynitride of the matrix at a heat treatment temperature, and optionally wherein the heat treatment temperature of the amorphous metal oxynitride is 900 °C to 1300 °C.

7. The vertical NAND flash memory device of any preceding claim, wherein the plurality of nanocrystals are buried in the matrix.

8. The vertical NAND flash memory device of any preceding claim, wherein one or more of the plurality of nanocrystals are provided in a boundary between the matrix and a layer adjacent to the matrix.

9. The vertical NAND flash memory device of any preceding claim, wherein each of the plurality of cell arrays is vertically provided to extend on a substrate.

10. The vertical NAND flash memory device of claim 9, further comprises a channel hole extending in a direction perpendicular to the substrate is formed inside the channel layer, and optionally wherein an inside of the channel hole is filled with an insulating layer.

11. The vertical NAND flash memory device of claim 10, wherein each of the channel layer and the charge trap layer is formed in a cylindrical shape surrounding the channel hole.

12. The vertical NAND flash memory device of claim 11, wherein the plurality of gate electrodes are spaced apart from each other in a direction perpendicular to the substrate, and
wherein each of the plurality of gate electrodes surrounds the charge trap layer.

13. The vertical NAND flash memory device of claim 11 or 12, further comprises a tunneling dielectric layer provided between the channel layer and the charge trap layer.

14. The vertical NAND flash memory device of any of claims 11 to 13, further comprises a barrier dielectric layer provided between the charge trap layer and each of the plurality of gate electrodes.

15. An electronic apparatus comprising a vertical NAND flash memory device according to any preceding claim.

# FIG. 1

# FIG. 2

110

121

115

A

115

MC

121

121

115

121

115

121

123  125b  125a  127  129  130        125b  125a

125        125

z

y ⊗ → x

# FIG. 3

121  115       123      125a  125b      127       129

125

FIG. 4A

amorphous AlON

10 nm

# FIG. 4B

wurtzite AlN
amorphous AlON
5 nm

# FIG. 5A

21  23  25  27  29

10

I — I'

W    AlO/SiO    SiN    SiON    Poly-Si

# FIG. 5B

W | AlO/SiO | SiN | SiON | Poly-Si

# FIG. 6A

100

125

121 123 127 129

II ⟶ II'

III ⟶ III'

W   AlO/SiO   AlON+AlN   SiON   Poly-Si

EP 4 489 545 A1

# FIG. 6B

W    AlO/SiO    AlON    SiON    Poly-Si

18

# FIG. 6C

W　　AlO/SiO　　AlON/AlN　　SiON　　Poly-Si

# FIG. 7

# FIG. 8A

# FIG. 8B

# FIG. 9A

Oxygen content (atomic fraction)

FIG. 9B

# FIG. 10

200

121  115        123        225b 225a  127        129

225

# FIG. 11

Europäisches
Patentamt

European
Patent Office

Office européen
des brevets

# EUROPEAN SEARCH REPORT

**Application Number**

EP 24 16 4383

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2022/238672 A1 (LEE MINHYUN [KR] ET AL) 28 July 2022 (2022-07-28) <br> * paragraph [0062] - paragraph [0093] * <br> * paragraph [0109] * <br> * paragraph [0114] * <br> * paragraph [0130] * <br> * figures 1, 2 * | 1-15 | INV. <br> H10B43/27 <br> H10B43/30 <br> H01L29/792 |
| Y | US 2009/096014 A1 (CHOI SAM-JONG [KR] ET AL) 16 April 2009 (2009-04-16) <br> * paragraph [0052] - paragraph [0053] * | 1-15 | |
| X | US 7 602 011 B2 (FUJITSU MICROELECTRONICS LTD [JP]) 13 October 2009 (2009-10-13) <br> * column 3, line 60 - column 10, line 52 * <br> * figures 1, 10 * | 1-15 | |
| E | EP 4 398 695 A1 (SAMSUNG ELECTRONICS CO LTD [KR]) 10 July 2024 (2024-07-10) <br> * the whole document * | 1-7,9-15 | |

**TECHNICAL FIELDS SEARCHED (IPC)**

H10B
H01L

The present search report has been drawn up for all claims

| Place of search | Date of completion of the search | Examiner |
|---|---|---|
| Munich | 20 August 2024 | Bruckmayer, Manfred |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

2

## ANNEX TO THE EUROPEAN SEARCH REPORT
## ON EUROPEAN PATENT APPLICATION NO.

EP 24 16 4383

This annex lists the patent family members relating to the patent documents cited in the above-mentioned European search report.
The members are as contained in the European Patent Office EDP file on
The European Patent Office is in no way liable for these particulars which are merely given for the purpose of information.

20-08-2024

| Patent document cited in search report | | | Publication date | Patent family member(s) | | | Publication date |
|---|---|---|---|---|---|---|---|
| US 2022238672 | A1 | | 28-07-2022 | CN | 114792692 | A | 26-07-2022 |
| | | | | EP | 4040489 | A1 | 10-08-2022 |
| | | | | US | 2022238672 | A1 | 28-07-2022 |
| US 2009096014 | A1 | | 16-04-2009 | JP | 2008306190 | A | 18-12-2008 |
| | | | | KR | 20080108826 | A | 16-12-2008 |
| | | | | US | 2009096014 | A1 | 16-04-2009 |
| US 7602011 | B2 | | 13-10-2009 | CN | 101061579 | A | 24-10-2007 |
| | | | | EP | 1818978 | A1 | 15-08-2007 |
| | | | | JP | WO2006059368 | A1 | 05-06-2008 |
| | | | | US | 2007228454 | A1 | 04-10-2007 |
| | | | | US | 2009325373 | A1 | 31-12-2009 |
| | | | | WO | 2006059368 | A1 | 08-06-2006 |
| EP 4398695 | A1 | | 10-07-2024 | CN | 118301938 | A | 05-07-2024 |
| | | | | EP | 4398695 | A1 | 10-07-2024 |
| | | | | KR | 20240109477 | A | 11-07-2024 |
| | | | | US | 2024221834 | A1 | 04-07-2024 |

EPO FORM P0459

For more details about this annex : see Official Journal of the European Patent Office, No. 12/82